# EUROPEAN PATENT SPECIFICATION

(11) **EP 1 799 880 B1**
(45) Date of publication and mention of the grant of the patent: **09.12.2009**
(21) Application number: 05797479.2
(22) Date of filing: 06.10.2005
(51) Int. Cl.: C09D 11/00, C23C 18/30, C23C 18/20, C23C 18/28, C23C 18/16

(54) **ACTIVE FILLER PARTICLES IN INKS**
AKTIVE FÜLLSTOFFTEILCHEN IN DRUCKFARBEN
PARTICULES DE CHARGE ACTIVES DANS DES ENCRES

(30) Priority: 08.10.2004 GB 0422386
(43) Date of publication of application: 27.06.2007
(73) Proprietor: QinetiQ Limited, London, SW1E 6PD (GB)
(72) Inventor: JOHNSON, Daniel, Robert, Qinetiq Limited, Malvern, Worcestershire WR14 3PS (GB); WILLIS, Richard, Lance, QinetiQ Limited, Farnborough, Hampshire GU14 0LX (GB); DAMERELL, William, Norman, QinetiQ Limited, Farnborough, Hampshire GU14 0LX (GB)
(74) Representative: Humphreys, Elizabeth Jane
(86) International application number: PCT/GB2005/003842
(87) International publication number: WO 2006/038011

(56) References cited:
- WO-A-02/099163
- US-A- 4 368 281
- US-A- 5 378 268

## Description

### FIELD OF THE INVENTION

The present invention relates to electroless deposition of metal coatings onto metallic or non-metallic, and especially plastic, substrates. Electroless deposition typically involves reduction of a metal salt in a reducing solution catalysed by an activator or sensitiser deposited on the substrate.

### BACKGROUND OF THE INVENTION

As described for example in US Patent 4,082,557, electroless deposition typically involves four steps:
1 Mordanting in which the articles to be metal coated are treated with acids, typically chromic and/or sulphuric acids, to render the surface wettable and microporous;
2 Sensitisation in which the mordanted surface is treated with stannous chloride and hydrochloric acid to deposit stannous chloride in the pores;
3 Activation in which the surfaces are immersed in a solution of a salt of a noble metal so that small quantities of noble metal are attached to the surface; and
4 Metal coating in which the surface is immersed in a solution containing a salt of the metal to be deposited and a reducing agent. The particles of noble metal catalyse the reduction of the metal salt resulting in deposition of the metal on the surface.

Typically the noble metal is palladium although platinum or gold have also been used. However such metals are expensive and it is desirable to use less expensive metals. Attempts have been made to use silver as an activation metal, but problems have been found with precipitation due to presence of chloride, daylight or to copper which causes deposition of metallic silver in a non-adherent form.

Metals deposited by electroless deposition can include copper, nickel, chrome, palladium and gold. Metals can act as both activator and as deposited metal.

US Patent 4,082,557 describes deposition of silver activator from solutions of silver nitrate complexed with boric acid, silicic acid, vanadic acid, arsenic acid, molybdic acid or wolframic acid. Alternatively US Patent 4,568,570 describes an activating solution containing silver chloride complexed with ammonia or amines. The complex is decomposed to the silver (1) salt on the surface of the substrate and reduced in situ. US Patent 5,300,140 describes an activating solution comprising silver complexed with an organic polymer. US5378268 is directed to the metalisation of surfaces using metal salts in non-polar solvents. US4368281 is directed to the metalisation of surfaces using silver complexes and WO 02/099163 is directed to the metalisation of surfaces using metals other than silver.

However it has hitherto not been possible to produce sufficiently uniform and adherent coatings from a silver nitrate activator from an aqueous solution without complexing agents.

Many etch processes used to create porosity in substrates to permit keying-in of electroless metals are hazardous, for example hexavalent chromium solutions with ABS plastics, Thus avoidance of the use of such chemicals is desirable.

Alternatively electroless deposition can be conducted onto a thick paste containing high loadings (typically 30-60%wt) of metallic silver. However such pastes are expensive and difficult to apply in fine patterns. A further problem when using a thick paste is that it may affect the subsequent adhesion of the electroless metal and any additional layers including electrodeposited metal layers. Additionally such high silver loadings pose a risk of leakage from waste sites.

### SUMMARY OF THE INVENTION

The invention provides a method of electroless deposition on a substrate, especially a plastic substrate which avoids the problems of using high percentage weight silver loaded pastes and avoids or reduces the use of hazardous or polluting surface preparations of the substrate to be coated, by using as an activating composition for the electroless plating an ink composition containing silver as a reducible silver salt. The ink composition may be any conventional ink suitable for printing on the substrate to be coated.

According to the invention a method of preparing a substrate material for subsequent metal plating by an autocatalytic deposition process comprising printing onto the substrate by a pattern transfer process an ink composition, comprising an ink formulation suitable for printing onto the substrate to be coated, silver as a reducible silver salt and filler particles, which are present in a polar solvent, such that said reducible silver salt is in the form of silver ions, and wherein said reducible silver salt is selected such that when reduced it is capable, once the coated substrate is introduced into an autocatalytic deposition solution, of catalysing the deposition of a metal from the autocatalytic deposition solution, onto the coated areas of the substrate, wherein the proportion of the reducible silver salt is such that the ink composition contains less than 10% w/w of silver. Preferably the silver salt comprises in the range of from 0.1 to 10% by weight of silver. More preferably in the range of from 0.25 to 2.5% by weight of silver.

According to a further aspect of the invention there is provided an ink composition for carrying out the method according to the invention, the ink composition comprising a printable ink, comprising a polar solvent a reducible silver salt in the form of silver ions and a particulate filler material. The particulate filler material may be specially added or may be an inherent component of the printable ink, for example a pigment.

### Detailed Description of the Invention

The silver salt may be any reducible silver salt wherein the counterion may be selected from any known organic or inorganic moiety, such as short chain (in the range of from C₁-C₆) alkoxy conveniently methoxide, ethoxide, acetate, citrate, acyloxy, or aryloxy, conveniently benzoate, diethyldithiocarbamate, carbonate, halide, preferably fluoride, bromide or iodide, nitrite, nitrate, oxide, perchlorate, permanganate, sulphite, sulphate, thiocyanate, or a silver protein. Preferably the reducible silver salt is silver nitrate.

The silver salt may be at least part soluble, preferably soluble, in the solvents employed in the ink in order to achieve dispersion within the ink formulation. Conveniently, fine solid dispersions of insoluble salts may also be used, provided they pass freely through the depositing head of the printing means. Conveniently, the reducible silver salt and /or filler may be added to a solvent before being added to the ink formulation, to aid the transfer and/or mixing of the reducible silver salt and ink formulation.

It will be understood that whereas the term ink implies pigment, pigment is not necessary for the invention. The ink formulation in the activating composition may thus be identical to conventional ink formulations but exclude any pigment. However if the ink formulation contains pigments, other spectroscopically active compounds, which emit and/or absorb light, then the pigment or spectroscopically active compounds may enable the integrity of the deposited activating ink to be monitored, either visually or by a suitable detector means.

Conveniently the spectroscopic compound may be selected from any known spectroscopically active compound, typically transition metals with one or more ligands. Typically spectroscopic compounds will absorb/emit light and so their presence can be detected either by the visual presence of colour, or by subjecting the compound to any suitable stimulus /activation, such as chemical, radiation, thermal, visible light or UV light.

It has been found previously that silver particles cannot be produced by reduction of metal salt using the electroless solution because the salts are coated with ink binder so that there is inadequate surface area for effective activation of the electroless plating, and as previously described the prior art overcame this problem by loading the inks at greater 50%w/w of silver metal, which proves both costly and difficult to deposit uniformly.

In a preferred embodiment the filler material will be a particulate filler material. It is believed (although the invention is not limited by this explanation) that the particulate filler acts to increase the texture, porosity and hence surface area of the resulting deposited coating and thereby increases the availability of the reduced silver. Suitable particulate fillers include ceramics, polymers, plastics, metals, metalloids, or non metals including their salts, examples of which may be selected from, but not limited to; titanium dioxide, carbon, calcium carbonate, calcium sulphate, alumina, silica, and copper oxide. The particulate filler may be in any suitable form, such as a powder, microsphere or micronised flake. The particles have dual roles in presenting a high surface area onto which the reducible silver salt is adsorbed and also maintaining ink viscosity and rheology without the need for additional ink binders which would tend to coat the reduced silver. The filler may be selected such that it may also provide bulk electrical conductivity in the ink composition, which enables connectivity to surfaces beneath the printed layer, for example to make electrical contacts to electrical components overprinted with this ink.

In deposition systems where ink is to be passed through a nozzle, such as, for example, inkjet may encounter problems when high percentages of particulate filler are used. Conveniently a printing ink formulation which posses, when dry, a high degree of porosity may allow for substantially zero amounts of filler to be used.

The diameter of the particulate filler particles may be selected depending on; the ink formulation, the method of deposition and the substrate to be coated. Conveniently the diameter of the particles is less than 100 µm, more preferably the particles are 10 µm or less in diameter, in some cases, sub micron or nano scale particles are used, such as particles which are 0.2µm, or less in diameter. Preferred particle ranges are 0.05 to 5µm or more preferably 0.2 to 2µm in diameter. The particulate filler particles may be selected to form complex distributions of particle size, one convenient distribution is bimodal distribution.

Alternatively inks comprise a proportion, often about 50% of volatile solvent which after printing evaporates to leave a dry ink composition. The particulate filler may comprise in the range of from 5 to 75 %w/w and preferably 10 to 50% w/w and especially 20 to 40% w/w of the dry ink composition excluding solvent. Advantageously it has been found that for ink formulations which may be passed through a nozzle such as, for example spray ink or inkjet printing that the particulate filler may comprise in the range of from 5 to 75 %w/w and preferably 5 to 50% w/w and especially 5 to 30% w/w.

The ink formulation may be selected from any suitable ink formulation or any suitable commercially available ink formulation. Conveniently the ink formulation may be selected depending on the surface properties of the substrate to be coated, preferably the ink formulation is selected such the ink and substrate are designed to posses maximise adhesion, conveniently it may be possible to avoid the mordanting step described above. This clearly leads to a resulting reduction in costs and pollution from waste materials. In some cases it may also be possible to avoid sensitisation with stannous chloride. The ink is preferably selected such that it is suitable for the substrate to be coated in accordance with known practice in the printing art.

The activating ink composition once deposited on the surface may need to be dried or cured to cause maximum adhesion between the ink and substrate. In one convenient mode of operation as the ink composition hits the surface of the substrate it undergoes immediate densification and may remove the need for porous substrates and /or surface preparation to avoid the dissipation or bleeding of the deposition promoting material on the substrate.

The ink composition may be dried or cured by thermal means, such as leaving the solvent to evaporate, at substantially room temperature conditions or causing the solvent to be removed by heating and/or subjecting the substrate to reduced pressure environment. Alternatively the ink may further contain a curable compound which is capable of forming a cured material. The polymerisation may be initiated by thermal means, a chemical radical initiator or radiation, conveniently electron beam, X-ray, ionising radiation or UV light, preferably UV light. The curable compound may be selected from a monomer, conveniently an organic monomer/oligomer comprising a polymerisable moiety, such as an electron rich bond, or a conjugated system to form a polymeric material.

Inks which may be cured by UV may comprise an ink composition according to the invention and may further comprise a photoinitiator, oligomers and/or monomers, and where necessary other solvents or filler particles. Oligomers may include eurymeric acrylates, such as alkoxylated acrylates with at least one ether linkage, ethoxylated acrylates, propoxylated acrylates, oligo/polyethylene glycol acrylates and oligo/polyropylene glycol acrylates, which may have mono-, di- tri-, tetra- etc. functional groups. Further eurymeric acrylates include acrylic acrylates, amine modified polyether acrylates and chlorinated polyester acrylates. Preferred acrylates are epoxy acrylates, urethane acrylates, polyester acrylates, melamine acrylates, amine synergists, silicone acrylates, polyether acrylates, and phosphate modified methacrylates. Oligomers may influence the structural properties of the cured ink in a similar way to resins in conventional inks.

Monomers may be selected from acrylates, diacrylates, triacrylates and carbazoles, which are selected to determine the viscosity of the ink composition. When subjected to polymerisation such as by UV irradiation, the monomer is able to cross-link with the oligomer to form the cured ink composition. Monomers may also be used without the oligomer. The monomer when subjected to polymerisation such as by UV irradiation may be used to provide the cured ink composition.

The photoinitiator initiates the cross-linking reaction under UV irradiation and the curable ink composition may comprise at least one photoinitiator or chemical initiator. The initiator may be selected from, benzophenone, n-methyldiethanolamine, 2-hydroxy-2-methyl-1-phenylpropan-1-one (HMPP), 2-hydroxy-1-[4-(2-hydroxyethoxy)phenyl]-2-methyl propan-1-one (HE-HMPP), or oligoHMPP, 1-hydroxy-cyclohexyl-phenylketone (HCPK).

Conveniently if the UV curable ink contains a spectroscopically active compound the resulting deposited material may absorb/emit light such that the integrity of the surface can be monitored.

Alternatively the ink composition may be cured by a chemical agent added after the ink or simultaneously by ink-jet or similar spray means as disclosed in patent application PCT04/017688.

In a yet further embodiment the ink may be selected such that upon drying or curing the dried ink has low porosity, but upon contact with the electroless deposition bath said cured ink may become porous to allow ingress of the electroless deposition solution.

In an alternative method for forming a patterned surface, an activating ink composition in accordance with the invention, comprising a UV curable ink formulation may be deposited across substantially all of the substrate to be coated, and a photo lithographic mask applied to said coated substrate, such that upon exposure to UV light only the desired pattern is cured, the remaining uncured ink may be removed. The cured ink may then be subjected to electroless deposition and/or further processes such as electrodeposition.

After applying the activating ink composition of the invention to the substrate and/or optionally curing said ink, it is further subjected to a reducing environment to reduce the silver salt to metallic silver. This may be achieved with a separate reducing solution, for example the substrate may be treated with stannous chloride before or after applying the ink composition. Alternatively the reducing agent in the electroless plating bath may be effective to reduce the silver salt. In this way the entire electroless plating process may be reduced to two steps: coating with an activating solution in accordance with the invention; followed by treatment with a conventional electroless plating solution containing a salt of the metal to be deposited and a reducing agent.

The ink formulation as described hereinbefore will be selected depending on the substrate to be coated, it may be desirable to add additional solvents to alter the viscosity of the ink depending on the method of deposition. The deposition of the ink composition may be carried out by any known deposition means such as spraying, brushing or printing means. Conveniently printing means may encompass inkjet, flexographic printing , gravure printing, relief printing, off-set lithographic printing, screen printing and other patterning processes including photolithography. It will be clear to the skilled man as to the required viscosity and rheology of the ink for any given printing process. In certain applications it may be desirable to avoid the use of any organic solvents, it will be clear to the skilled operator as to the selection of a water based ink that may be used in respect to any given deposition method.

The deposited activating composition of the invention may be used with conventional electroless plating solutions which may comprise any noble metal, such as copper, cobalt, nickel, and alloys of these or iron. It may be used for electroless deposition of nickel from solutions of nickel salts and complexes and containing strong reducing agents such as dimethylamineborane, DMAB, other boranes and hydrazine. However it may not be suitable for some electroless plating solutions such as nickel/hypophosphite.

The electroless solution comprises metal ions, complexing agent(s), reducing agent(s) and may be pH corrected to ensure the electroless deposition reaction occurs between the reducing agent and metal ions on the cured and optionally reduced activating ink composition. The electroless deposition solution is usually heated to increase the reaction rate. For electroless copper or electroless nickel using DMAB reducing agent, the solutions may be conveniently operated at an elevated temperature, ideally in the range 40 to 50°C. The electroless metal deposits only on the portions where the activating ink is deposited and substantially none on the surrounding substrate. The electroless metal continues to deposit onto the activating ink owing to the already deposited electroless metal being autocatalytic to its own electroless deposition. A further advantage of the technology is that the metal can be grown to a controlled thickness, determined by immersion time in the electroless solution.
A further advantage of the present invention is the electroless metal deposits onto and/or into the deposited activating ink enabling it to key-in and thus improving the adhesion to the ink and hence substrate.

The substrate coated with the electroless plate according to the invention, may be further subjected to additional electroless plating solutions and/or conventional electroplating processes, to deposit either an increased thickness of metal and/or to deposit alternative metal(s) to that selected in the original electroless deposition bath, to form a metal plated coating on some or all of the at least one surface of the substrate. Conveniently a further substrate may be formed on and/or applied to the finished or substantially finished metal plated coating and a further process of deposition of ink and electroless metal and /or electrodeposition according to the invention may be carried out, to form a plurality of metal coated substrate layers.

The substrate may be selected from any material, conveniently such material may include metal or their alloys therein, non-metal, metalloid, conveniently semiconductors, polymer, plastic, fibre or ceramic. The ink may be deposited on at least one side of the substrate. The substrate may be plannar or non-plannar, such as for example a curved surface or a 3-D shape. One convenient substrate would be a rigid or flexible polymer capable of supporting a printed circuit, the polymer may be coated on at least one side, or at least two sides, and optionally the edges and/or through holes.

The deposited pattern may form an electrical path, such as to provide connection between components on a printed circuit, optionally the deposited pattern may form part or substantially all of an electronic component, which forms part of an electronic circuit.

Conveniently the width of the deposited material may be controlled by the printing means, ie from the mesh size of a printing means or from repeated passes of the printing means. Conveniently the thickness of the metal coating can be controlled by the electroless and/or electrodepostion processes. The thickness of electroless and electrodeposited metals are dependent on the rate of deposition and exposure time to their respective chemistries and heat and in the latter to the supply of electrical power to provide the reduction potential and current flow to the metal depositing at the cathode.

The metal coated substrate may also be used to produce; radio frequency identification (RFID) tags. The tag read range is affected by the thickness of metal used. UHF antenna elements in RFID can be made to absorb less electromagnetic energy owing to the effect of metal thickness on skin depth. Skin depth and the effect of electrical resistance influence the resonant frequency impedance and hence read range in EAS tags used in the Checkpoint® system. The metal may also be overprinted with other materials for added function, for example to manufacture electrochemical storage batteries or capacitor devices. Application areas for the metal alone may include frequency selective surfaces, FSS, printed circuits, PCB, electromagnetic screening and general metal finishing, GMF.

Examples of ink formulations according to the current invention.
Convenient commercial off the shelf inks (although the invention is not limited by these inks) that may be used are Acheson 6018S® white insulating screen ink or Acheson Electrodag PR-400® ink.

**Table 1**

| Ink Number | Print Technology | Cure Technology | Base ink | Catalytic Content (/kg) | Catalytic added in |
|---|---|---|---|---|---|
| 1 | Flatbed Screen | Thermal Drying | 6018S | 5g AgNO3 | 20ml ethyl lactate + 5ml H2O |
| 2 | Flatbed Screen | Thermal Drying | 6018S | 5g AgNO3 | 20m ethyl lactate + 5ml H2O |
| 3 | Rotary Screen | Thermal Drying | 6018S | 5g AgNO3 | 20ml ethyl lactate + 5ml H2O |
| 4 | Flexo | Thermal Drying | 6018S | 5g AgNO3 | 20m ethyl lactate + 5ml H2O |
| 5 | Spray Gun | Thermal Drying | 6018S | 5g AgNO3 | 20m ethyl lactate + 5ml H2O |
| 6 | Spray Gun | Thermal Drying | 6018S | 5g AgNO3 | 20m ethyl lactate + 5ml H2O |

Table 2, below, shows some preferred ranges of components for solvented inks.

**Table 2 Solvented drying (non-polymeric cure) ink formulations**

| Application method | % Inert filler | % Inert polymer | % Ink solvent | % Silver salt | % Silver salt solvent |
|---|---|---|---|---|---|
| Flatbed Screen | 10-50 | 10-50 | 20-50 | 0.1-10 | 0-10 |
| Rotary Screen | 10-50 | 10-50 | 20-50 | 0.1-10 | 0-10 |
| Spray Paint | 5-30 | 5-30 | 30-75 | 0.1-10 | 0-10 |
| Inkjet | 1-30 | 0-25 | 25-90 | 0.1-10 | 0-10 |

Table 3, below, shows some preferred ranges of components for UV curing inks.

**Table 3 UV curing ink formulations**

| Application Method | % Inert filler | % Inert resin | % Monomer package | % Initiator package | % Silver salt | % Silver salt solvent |
|---|---|---|---|---|---|---|
| Flatbed Screen | 10-50 | 1-20 | 30-90 | 1-10 | 0.1-10 | 0-10 |
| Rotary Screen | 10-50 | 1-20 | 30-90 | 1-10 | 0.1-10 | 0-10 |
| Inkjet | 0-30 | 1-20 | 25-90 | 1-10 | 0.1-10 | 0-10 |

All values in Tables 1 to 3 are based on weight percentage of the wet inks.

### Description of the Drawings

Embodiments of the present invention will now be described with reference to the accompanying drawings in which:
Figure 1 shows the deposited ink composition on the surface of a substrate.
Figure 2 shows the individual agglomerates of the filler, binder and reducible metal on the surface of a substrate.
Figure 3 shows an expanded view of an agglomerate particle, showing the ions and the reduced metal.

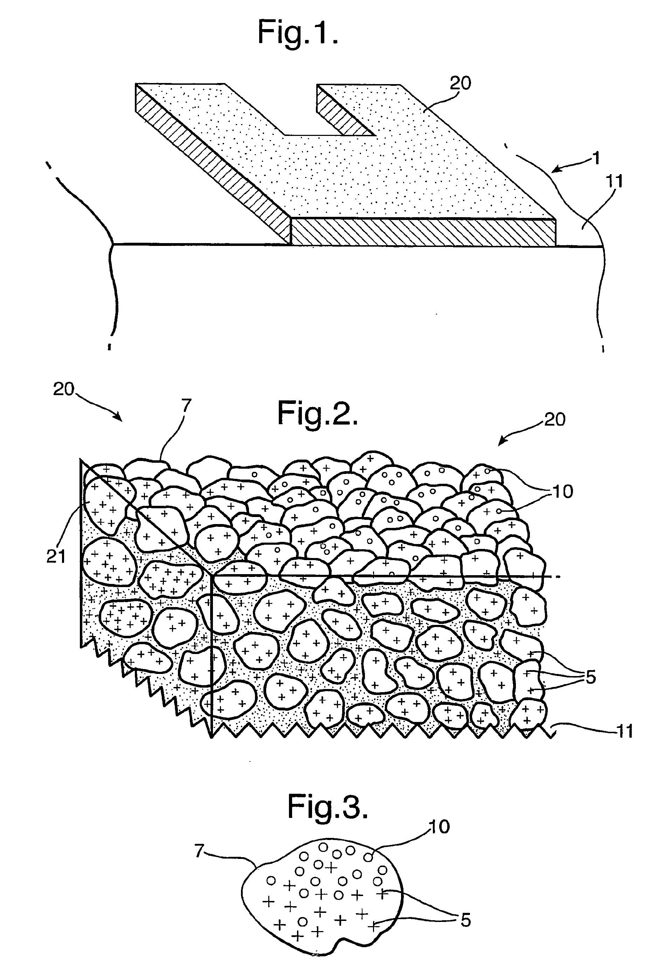

Figure 1, shows an activating ink composition (20) according to the invention deposited onto the top surface (11) of a substrate (1). The deposited ink composition (20) may be a pattern which covers part of the surface(11), or it may cover the entire surface(11) of the substrate. The ink formulation (which makes up the activating ink composition) is suitably selected depending on the substrate chosen to form a strong bond when cured/solidified either by thermal curing, conveniently natural evaporation, a reduced pressure atmosphere or UV cross linking.

Figure 2 shows a magnified version of the cured activating ink composition (20). The ink additionally contains filler particles which act to increase the available surface area of silver ions (5), represented by the "+" symbol. If the ink is UV curable the ink may also contain a polymerisable moiety as hereinbefore described. The ink, filler and silver ions form an agglomeration of discrete packages (21).

The silver ions (5) in the discrete packages (21), can be chemically reduced to metal, when exposed to a chemical reducing agent, which may include those employed in an electroless metal deposition solution. The reducing agent may involve ions such as hydride, (H"), The reducing agent converts the silver ions (5), to silver metal (10) denoted by the symbol "o". The silver metal (10) may then be used to catalyse electroless metal deposition of less noble metals for example copper, nickel, Alternatively it may undergo exchange with a metal more noble than itself(ones less electropositive) such as palladium or gold, which may also initiate electroless deposition of metals.

Figure 3 A filler particle(4) is shown in yet higher magnification, which has a surface (7) that contains a concentration of silver ions(5), exposed to the reducing agent by enabling solution to percolate in from the surface of the cured ink composition(20) not shown. As a result the silver ions(5) adsorbed on the particle are reduced to silver metal (10). Returning to figure 2, The discrete packages(21) which are deposited by a printing means adhere to the surface (11) of the substrate (1). The surface (7) of the outer most discrete packages(21) when cured forms an outer surface(12) of the ink composition(20). The metal(10) catalyses the deposition of electroless metal both onto and into the surface (12). Some of the electroless deposited metal will deposit on the silver metal(10) which lies beneath the surface (12) to provide a key for subsequent deposition, improving the overall electroless metal adhesion to the ink composition (20).

Specific Examples

### Example 1

A screen printing ink (supplied under the trade mark Acheson 6018S) was used as the ink formulation, to which was added titanium dioxide 2 µm at 30 % by weight as a filler there was no reducible silver salt present. The control ink composition was screen printed onto two sides of a sheet of polyester in the design of a "Checkpoint®" system electronic article surveillance, (EAS), 1-bit tag.

The ink was cured by heating the sample to 80°C for 10 minutes, causing the ink composition to solidify and adhere to the substrate. At this stage the ink had no electrical conductivity. The printed pattern of cured ink was then immersed into a solution of commercially available Enthone 2130® electroless copper at 46°C as expected there was no electroless deposition of copper metal.

### Example 2

A screen printing ink (supplied under the trade mark Acheson 6018S) was used as the ink formulation, to which was added titanium dioxide 2 µm at 30 % by weight as a filler and silver nitrate 3% by weight. The silver nitrate was pre-dissolved in an aliquot of ethyl lactate/ water to aid the transfer and mixing with the screen printing ink. The activating ink composition was screen printed onto two sides of a sheet of polyester in the design of a "Checkpoint®" system electronic article surveillance, (EAS), 1-bit tag. This tag behaves as an inductively coupling resonator and employs an inductor, L and capacitor, C. A tag of this type can be made to resonate at a selected frequency by changing the design to provide different values of inductance and capacitance.

The ink was cured by heating the sample to 80°C for 10 minutes, causing the ink composition to solidify and adhere to the substrate. At this stage the ink had no electrical conductivity. The printed pattern of cured ink was then immersed into a solution of commercially available Enthone 2130® electroless copper at 40°C and copper metal deposited to a thickness in the range of from 0.1 to 2 microns onto the printed pattern. An effective EAS tag requires greater than 2 microns of metal owing to low absorption of electromagnetic energy at this frequency and the electrical resistance of the inductor coil. Conveniently the copper thickness on the tag was then increased using electrodeposition to 20 microns. This was achieved by making an electrical connection from the electroless copper layer to the negative terminal of a power supply and a copper rod connected to the positive terminal. When both were placed and held separate in a solution of Enthone cuprostar® copper electroplating solution and a voltage of 0.5 volts applied, then copper electroplated onto the electroless deposited metal. After electroplating was complete and the metal coated pattern rinsed and dried, through-hole connections were made to complete the LC circuit of the tag. It was found to operate as effectively as commercial EAS products, having a resonant frequency of 8.2MHz and impedance of 10 kiloohms.

### Example 3

The same ink used in example 2 was printed and cured into the design of a dipole antenna and also a patch antenna, both commonly employed in UHF RFID tags and other communications devices. The ink composition was cured by heating to 80°C, which when solidified was immersed in the same solution of electroless copper used in example 1. Electroless copper deposited onto the printed ink to a thickness of 2 microns. In this instance the designs did not cause high resistance losses for the thickness of metal and the operating frequency meant that sufficient electromagnetic energy could be absorbed and re-emitted to provide effective devices, without the need for electrodeposited metal.

### Example 4.

The same printed and cured ink and pattern described in example 2 was immersed into the same electroless solution to deposit 0.5 microns of electroless metal, The electroless copper was subjected to the electrodeposition method employed in example 2, to produce a final thickness of 5 microns. The antenna devices were found to be as effective as those cited in example 2.

### Example 5.

A screen printing ink (supplied under the trade mark Acheson Electrodag PR-400) was used as the ink formulation, to which was added carbon as a filler and silver nitrate 3% by weight, The silver nitrate was pre-dissolved in an aliquot of ethyl lactate/ water to aid the transfer and mixing with the screen printing ink. The pattern as described in example 2 was screen printed onto a polyester substrate, the ink was cured by drying for 10 minutes at 80°C and immersed in an electroless copper deposition solution as described in example 1 and copper was deposited to a thickness of 2 microns. In this instance the metal provided surface conduction and the ink through-conduction to the substrate beneath.

### Example 6

A screen printing ink (supplied under the trade mark Acheson 6018S) was used as the base of the formulation to formulate a flat bed screen ink The ink, as supplied, was blended with 10% organic solvent (a 50/50 blend of 1-methoxy-2-propanol and ethyl lactate) then an aliquot of silver nitrate equal to 0.6% of the final mass of the ink, pre-dissolved in a volume of DMSO (equal to 3.5% of the final mass of the ink) was added. A further 5% w/w of organic solvent was then added and the whole mixed thoroughly to aid the blending of the catalyst mixture into the ink. The ink is then suitable for flat bed screen applications where additional organic solvents can be added, if required by the screen printer operator, up to a further 20% of the mass of the ink. The ink can then be plated with copper by submersion in an electroless copper bath as described in examples 1-5.

### Example 7

A screen printing ink (supplied under the trade mark Acheson 6018S) was used as the base of the formulation to formulate a sprayable ink. The ink, as supplied, was blended with 50% organic solvent (a 50/50 blend of 1-methoxy-2-propanol and ethyl lactate) then an aliquot of silver nitrate equal to 0,5% of the final mass of the ink, pre-dissolved in a volume of DMSO (equal to 3.5% of the final mass of the ink) was added. A further 50% w/w of a suitable organic solvent (specifically a 50/50 blend of 1-methoxy-2-propanol and diethylene glycol ethyl ether) was then added and the whole mixed thoroughly to aid the blending of the catalyst mixture into the ink. The ink was then filtered through a fine mesh before being transferred to a commercial spray gun (such as the DeVilbiss SRi range) and can be used to coat 2D or 3D surfaces. The ink was then dried at 80°C for 20 minutes to ensure all the solvent was removed then plated as described in the previous examples.

### Example 8

An inkjet ink suitable for commercial inkjet print heads may be formed by preparing a dilute solution (50mg/ml) of a suitable polymer, such as a selection from Wacker Chemical's Pioloform range, in ethyl lactate was mixed in a 50/50 ratio with a pre-dissolved solution of silver nitrate in 10/90 water/ethyl lactate. After dispersion this mixture is suitable for printing via commercial inkjet heads.

### Example 9

An inkjet ink suitable for HP Deskjet print heads was prepared by using an aqueous solution of silver nitrate in the range 0.1 to 0.5 molar concentration with additional polar solvents to aid inkjet printing of the solution onto suitable substrates. The solvents include for example propan-2-ol, diethylene glycol ethyl ether, ethyl lactate, or isopropyl lactate, added in the range 5 to 20% by volume. Other material may be included, for example colloidal crosslinking polymers, water soluble polymers that are insoluble in alkaline solution, water soluble polymers insoluble in acid solutions, UV monomer/activator dispersions, laponite clays. Surfactants may also be added in the range 0.01 to 0.1 % by weight to aid wetting of the ink onto the substrate. The substrate can either contain an ink receptive porous surface, an oxidised surface, textured or simply untreated. For porous surfaces, the substrate needs to be pre-treated with a solution of tin II chloride in the concentration range 0.05 to 0.5molar and the solution comprising water or propan-2-ol or mixtures of both. The tin chloride absorbed into the porous material acts to react and precipitate out silver entering the surface hence accumulating it there and preventing excessive absorption and dilution of the active silver species. A Hewlett Packard deskjet printer, type 5550 was used to print the water based silver salt-containing ink onto a substrate of Peachcoat, a porous ink receptive PET sheet substrate supplied by Nisshinbo of Japan and pre-treated with the tin II chloride. The printed image was dried and immersed into an electroless copper solution at 46 degrees Celsius and is metal deposited on the ink.

### Example 10

A UV curing ink (supplied under the trade mark Gibbon SUVO0024 Clear Writable Varnish) was used as the base of the formulation to formulate a UV curing ink for flatbed and rotary screen applications The ink, as supplied, was blended with silver nitrate equal to 3% of the total mass of the ink pre-dissolved in a volume of DMSO equal to 5% of the final mass of the ink. After thorough mixing this product may be suitable for use on flab bed or rotary screen equipment. The ink was printed and cured on standards print equipment in accordance with the commercial product data sheet and then plated with electroless copper as described in the previous examples.

## Claims

1. A method of preparing a substrate material for subsequent metal plating by an autocatalytic deposition process comprising printing onto the substrate by a pattern transfer process an ink composition, comprising an ink formulation suitable for printing onto the substrate to be coated, silver as a reducible silver salt and filler particles, which are present in a polar solvent, such that said reducible silver salt is in the form of silver ions, and wherein said silver salt is selected such that when reduced is capable, once the coated substrate is introduced into an autocatalytic deposition solution, of catalysing the deposition of a metal from the autocatalytic deposition solution, onto the coated areas of the substrate, and wherein the proportion of the reducible silver salt is such that the ink composition contains less than 10% by weight of silver.

2. A method according to claim 1 wherein the silver ions are adsorbed onto the filler particles.

3. A method according to claim 1 or 2 wherein the ink composition contains less than 1% by weight of silver.

4. A method according to claim 3 wherein the ink composition contains less than 0.1% by weight of silver.

5. A method according to any one of the preceding claims wherein the reducible silver salt comprises a counterion, wherein the counterion selected from any organic or inorganic counterion.

6. A method according to claim 5 wherein the organic counterion is selected from C₁ - C₆ alkoxy acetate, citrate, acyloxy, or aryloxy, benzoate, or silver protein.

7. A method according to claim 5 wherein the inorganic counterion is selected from nitrate, diethyldithiocarbamate, carbonate, iodide, bromide, nitrite, oxide, perchlorate, permanganate, sulphite, sulphate, thiocyanate.

8. A method according to claim 7 wherein the counterion is nitrate.

9. A method according to any one of the preceding claims wherein the ink composition is curable by thermal radiation.

10. A method according to any one of claims 1-8, wherein the ink composition is curable by Ultra Violet radiation.

11. A method according to any one of the preceding claims wherein the ink comprises a further metal or metal salt.

12. A method according to any one of the preceding claims wherein the ink comprises a further pigment or spectroscopically active material.

13. A method according to any one of the preceding claims wherein the filler particles are selected from particles of ceramics, polymers, plastics, metals, metal salts, metalloids, or non metals.

14. A method according to claim 13 wherein the filler particles are selected from titanium dioxide, carbon, calcium carbonate, calcium sulphate, alumina, silica or copper oxide.

15. A method according to claim 14 wherein the filler particles are selected from titanium dioxide.

16. A method according to any one of the preceding claims wherein the diameter of the filler particles is less than 100µm.

17. A method according to claim 16 wherein the diameter of the filler particles is in the range of from 0.05 to 5µm.

18. A method according to claim 17 wherein the diameter of the filler particles is in the range of from 0.2 to 2µm.

19. A method according to any one of the preceding claims wherein the filler particles are present in the range of from 5 to 75% w/w of the dry ink composition.

20. A method according to claim 19 wherein the filler particles are present in the range of from 10 to 50% w/w of the dry ink composition.

21. A method according to claim 20 wherein the filler particles are present in the range of from 20 to 40% w/w of the dry ink composition.

22. A method of metal plating a substrate by an autocatalytic deposition process comprising the steps of:
a) preparing the substrate material according to the method of preparing a substrate material as claimed in any preceding claim, and
b) introducing the prepared substrate material from step (a) into an autocatalytic deposition solution, the autocatalytic solution comprising a metal salt and a reducing agent.

23. An ink composition for carrying out the method according to anyone of the preceding claims, the ink composition comprising a printable ink, comprising a polar solvent reducible silver salt in the form of silver ions and a particulate filler material.

24. An ink according to claim 23 wherein the particulate filler material is selected from ceramics, polymers, plastics, metals, metal salts, metalloids, or non-metals.

25. An ink according to claim 24 wherein the particulate filler material is selected from titanium dioxide, carbon, calcium carbonate, calcium sulphate, alumina, silica or copper oxide

26. An ink composition according to any one of claims 23 to 25, wherein the reducible silver salt is pre-dissolved in a polar solvent comprising an aqueous solution or DMSO.

27. An ink according to any one of claims 23 to 26, wherein the reducible silver salt is silver nitrate and the particulate filler material is titanium dioxide particles, which are present in the range of from 5 to 75% w/w.

28. A substrate having deposited thereon an ink composition according to any one of claims 23 to 27, onto a substrate according to a method as defined in any one of claims 1 to 22,

29. A kit for depositing an ink composition according to any one of claims 23 to 27, onto a substrate, according to a method as defined in any one of claims 1 to 22.

30. Use of an ink composition according to claims 23 to 27, to deposit onto a substrate a deposition promoting material for electroless deposition.

## Patentansprüche

1. Verfahren zur Herstellung eines Substratmaterials für eine anschließende Metallplattierung durch einen autokatalytischen Abscheidungsprozess, welches das Drucken einer Druckfarbenzusammensetzung auf das Substrat durch einen Bildmusterübertragungsprozess umfasst, wobei die Druckfarbenzusammensetzung eine Druckfarbenformulierung, die zum Bedrucken des zu beschichtenden Substrats geeignet ist, Silber als reduzierbares Silbersalz sowie Füllstoffpartikel enthält, die in einem polaren Lösungsmittel vorliegen, sodass das reduzierbare Silbersalz in Form von Silberionen vorliegt, wobei das Silbersalz so ausgewählt wird, dass es, wenn es reduziert ist, befähigt ist, nach Einbringen des beschichteten Substrats in eine autokatalytische Abscheidungslösung die Abscheidung eines Metalls aus der autokatalytischen Absclzeidungslösung auf den beschichteten Bereichen des Substrats zu katalysieren, und wobei der Mengenanteil des reduzierbaren Silbersalzes so ist, dass die Druckfarbenzusammensetzung weniger als 10 Gew.-% Silber enthält.

2. Verfahren nach Anspruch 1, bei dem die Silberionen auf den Füllstoffpartikeln adsorbiert sind.

3. Verfahren nach Anspruch 1 oder 2, bei dem die Druckfarbenzusaimmensetzung weniger als 1 Gew.-% Silber enthält.

4. Verfahren nach Anspruch 3, bei dem die Druckfarbenzuaammensetzung weniger als 0,1 Gew.-% Silber enthält.

5. Verfahren nach einem der vorhergehenden Ansprüche, bei dem das reduzierbare Silbersalz ein Gegenion aufweist, wobei das Gegenion unter beliebigen organischen oder anorganischen Gegenionen ausgewählt ist.

6. Verfahren nach Anspruch 5, wobei das organische Gegenion unter C₁-C₆-Mkoxyacetaten, Citrat, Acyloxy, Aryloxy, Benzoat oder Silberprotein ausgewählt ist.

7. Verfahren nach Anspruch 5, wobei das anorganische Gegenion ausgewählt ist unter Nitrat, Diethyldithiocarbamat, Carbonat, Iodid, Bromid, Nitrit, Oxid, Perchlorat, Permanganat, Sulfit, Sulfat und Thiocyanat.

8. Verfahren nach Anspruch 7, wobei das Gegenion Nitrat ist.

9. Verfahren nach einem der vorhergehenden Ansprüche, bei dem die Druckfarbenzusammensetzung durch thermische Bestrahlung härtbar ist.

10. Verfahren nach einem der Ansprüche 1 bis 8, bei dem die Druckfarbenzusammensetzung durch Ultraviolettstrahlung härtbar ist.

11. Verfahren nach einem der vorhergehenden Ansprüche, bei dem die Druckfarbe ein weiteres Metall oder Metallsalz enthält.

12. Verfahren nach einem der vorhergehenden Ansprüche, bei dem die Druckfarbe ein weiteres Pigment oder spektroskopisch aktives Material enthält.

13. Verfahren nach einem der vorhergehenden Ansprüche, bei dem die Füllstoffpartikel unter Partikeln aus Keramikmaterialien, Polymeren, Kunststoffe, Metallen, Metallsalzen, Metalloiden oder Nichtmetallen ausgewählt sind.

14. Verfahren nach Anspruch 13, bei dem die Füllstoffpartikel unter Titandioxid, Kohlenstoff, Calciumcarbonat, Calciumsulfat, Aluminiumoxid, Siliciumoxid oder Kupferoxid ausgewählt sind.

15. Verfahren nach Anspruch 14, bei dem die Füllstoffpartikel unter Titandioxid ausgewählt sind.

16. Verfahren nach einem der vorhergehenden Ansprüche, wobei der Durchmesser der Füllstoffpartikel kleiner als 100 µm ist.

17. Verfahren nach Anspruch 16, wobei der Durchmesser der Füllstoffpartikel im Bereich von 0,05 bis 5 µm liegt.

18. Verfahren nach Anspruch 17, wobei der Durchmesser der Füllstoffpartikel im Bereich von 0,2 bis 2 µm liegt.

19. Verfahren nach einem der vorhergehenden Ansprüche, bei dem die Füllstoffpartikel in einem Mengenanteil im Bereich von 5 bis 75 Gew.-% vorliegen, bezogen auf die trockene Druckfarbezusammensetzung.

20. Verfahren nach Anspruch 19, bei dem die Flillstoffpartikel in einem Mengenanteil im Bereich von 10 bis 50 Gew.-% vorliegen, bezogen auf die trockene Druckfarbenzusammensetzung.

21. Verfahren nach Anspruch 20, bei dem die Füllstoffpartikel in einem Mengenanteil im Bereich von 20 bis 40 Gew.-% vorliegen, bezogen auf die trockene Druckfarbenzusammensetzung.

22. Verfahren zur Metallplattierung eines Substrats durch einen autokatalytischen Abscheidungsprozess, das folgende Schritt umfasst:
a) Herstellen des Substratmaterials nach dem Verfahren zur Herstellung eines Substratmaterials nach einem der vorhergehenden Ansprüche
und
b) Einbringen des hergestellten Substratmaterials aus Schritt a) in eine autokatalytische Abscheidungslösung, wobei die autokatalytische Lösung ein Metallsalz und ein Reduktionsmittel enthält.

23. Druckfarbenzusammensetzung zur Durchführung des Verfahrens nach einem der vorhergehenden Ansprüche, wobei die Druckfarbenzusammensetzung eine druckbare Druckfarbe enthält, die ein polares Lösungsmittel, ein reduzierbares Silbersalz in Form von Silberionen und ein partikelförmiges Füllstoffmaterial enthält.

24. Druckfarbe nach Anspruch 23, bei der das partikelförmige Füllstoffmaterial unter Keramikmaterialien, Polymeren, Kunststoffen, Metallen, Metallsalzen, Metalloiden oder Nichtmetallen ausgewählt ist.

25. Druckfarbe nach Anspruch 24, bei der das partikelförmige Füllstoffmaterial unter Titandioxid, Kohlenstoff, Calciumcarbonat, Calciumsulfat, Aluminiumoxid, Siliciumoxid oder Kupferoxid ausgewählt ist.

26. Druckfarbenzusammensetzung nach einem der Ansprüche 23 bis 25, bei der das reduzierbare Silbersalz in einem polaren Lösungsmittel, das eine wässerige Lösung oder DMSO umfasst, vorgelöst ist.

27. Druckfarbe nach einem der Ansprüche 23 bis 26, bei der das reduzierbare Silbersalz Silbernitrat ist und das partikelförmige Füllstoffmaterial aus Partikeln aus Titandioxid besteht, die in einem Mengenanteil im Bereich von 5 bis 75 Gew.-% vorliegen.

28. Substrat, das nach einem Verfahren nach einem der Ansprüche 1 bis 22 erhalten ist und auf dem eine Druckfarbenzusammensetzung nach einem der Ansprüche 23 bis 27 abgeschieden ist.

29. Kit zum Abscheiden einer Druckfarbenzusammensetzung nach einem der Ansprüche 23 bis 27 auf einem Substrat, das nach einem Verfahren nach einem der Ansprüche 1 bis 22 hergestellt ist.

30. Verwendung einer Druckfarbenzusammensetzung nach den Ansprüche 23 bis 27 zum Abscheiden eines die Abscheidung fördernden Materials zur stromlosen Abscheidung auf einem Substrat.

## Revendications

1. Procédé de préparation d'un substrat en vue d'un plaquage métallique ultérieur par un procédé de dépôt autocatalytique, comprenant l'impression d'une composition d'encre sur le substrat par un procédé de transfert de motif, comprenant une formulation d'encre adaptée pour une impression sur le substrat à revêtir, de l'argent comme sel d'argent réductible et des particules de charge, qui sont présentes dans un solvant polaire, de sorte que ledit sel d'argent réductible soit sous la forme d'ions argent, et dans lequel ledit sel d'argent est choisi de sorte que, lorsqu'il est réduit, il soit capable, une fois que le substrat revêtu a été introduit dans une solution de dépôt autocatalytique, de catalyser le dépôt d'un métal provenant de la solution de dépôt autocatalytique, sur les zones revêtues du substrat, et dans lequel la proportion du sel d'argent réductible est telle que la composition d'encre contient moins de 1.0 % en poids d'argent.

2. Procédé selon la revendication 1, dans lequel les ions argent sont adsorbés sur les particules de charge.

3. Procédé selon la revendication 1 ou 2, dans lequel la composition d'encre contient moins de 1 % en poids d'argent.

4. Procédé selon la revendication 3, dans lequel la composition d'encre contient moins de 0,1. % en poids d'argent.

5. Procédé selon l'une quelconque des revendications précédentes dans lequel le sel d'argent réductible comprend un contre-ion, et où le contre-ion est choisi parmi n'importe quel contre-ion organique ou inorganique.

6. Procédé selon la revendication 5, dans lequel le contre-ion organique est choisi parmi l'acétate d'alcoxy en C₁-C₆, le citrate, l'acyloxy, ou l'aryloxy, le benzoate et la protéinate d'argent.

7. Procédé selon la revendication 5, dans lequel le contre-ion inorganique est choisi parmi le nitrate, le diéthyldithiocarbamate, le carbonate, l'iodure, le bromure, le nitrite, l'oxyde, le perchlorate, le permanganate, le sulfite, le sulfate, le thiocyanate.

8. Procédé selon la revendication 7, dans lequel le contre-ion est un nitrate.

9. Procédé selon l'une quelconque des revendications précédentes, dans lequel la composition d'encre est durcissable par rayonnement thermique.

10. Procédé selon l'une quelconque des revendications 1-8, dans lequel la composition d'encre est durcissable par rayonnement ultraviolet.

11. Procédé selon l'une quelconque des revendications précédentes, dans lequel l'encre comprend un autre métal ou sel métallique.

12. Procédé selon l'une quelconque des revendications précédentes, dans lequel l'encre comprend un autre pigment ou un matériau spectroscopiquement actif.

13. Procède selon l'une quelconque des revendications précédentes, dans lequel les particules de charge sont choisies parmi des particules de céramique, de polymères, de matière plastique, de métaux, de sels métalliques, de métalloïdes et de non-métaux.

14. Procédé selon la revendication 13, dans lequel les particules de charge sont choisies parmi le dioxyde de titane, le carbone, le carbonate de calcium, le sulfate de calcium, l'alumine, la silice et l'oxyde de cuivre.

15. Procédé selon la revendication 14, dans lequel les particules de charge sont choisies parmi le dioxyde de titane.

16. Procédé selon l'une quelconque des revendications précédentes, dans lequel le diamètre des particules de charge est inférieur à 100 µm.

17. Procédé selon la revendication 16, dans lequel dans lequel le diamètre des particules de charge va de 0,05 à 5 µm.

18. Procédé selon la revendication 17, dans lequel dans lequel le diamètre des particules de charge va de 0,2 à 2 µm.

19. Procédé selon l'une quelconque des revendications précédentes, dans lequel les particules de charge sont présentes dans la gamme de 5 à 75 % en poids de la composition d'encre sèche.

20. Procédé selon la revendication 1.9, dans lequel les particules de charge sont présentes dans la gamme de 10 à 50 % en poids de la composition d'encre sèche.

21. Procédé selon la revendication 20, dans lequel les particules de charge sont présentes dans la gamme de 20 à 40 % en poids de la composition d'encre sèche.

22. Procédé de plaquage métallique d'un substrat par un procédé de dépôt autocatalytique comprenant les étapes consistant à :
a) préparer le substrat selon le procédé de préparation d'un substrat selon l'une quelconque des revendications précédentes, et
b) introduire le substrat prépare dans l'étape (a) dans une solution de dépôt autocatalytique, la solution autocatalytique comprenant un sel métallique et un agent réducteur.

23. Composition d'encre pour réaliser le procédé selon l'une quelconque des revendications précédentes, ladite composition d'encre comprenant une encre imprimable, comprenant un sel d'argent réducteur dans un solvant polaire sous la forme d'ions argent et une charge particulaire.

24. Encre selon la revendication 23, dans laquelle le matériau de charge particulaire est choisi parmi la céramique, les polymères, les matières plastiques, les métaux, les sels métalliques, les métalloïdes, et les non-métaux.

25. Encre selon la revendication 24, dans laquelle le matériau de charge particulaire est choisi parmi le dioxyde de titane, le carbone, le carbonate de calcium, le sulfate de calcium, l'alumine, la silice et l'oxyde de cuivre.

26. Composition d'encre selon l'une quelconque des revendications 23 à 25, dans laquelle le sel d'argent réductible est pré-dissous dans un solvant polaire comprenant une solution aqueuse ou du DMSO.

27. Encre selon l'une quelconque des revendications 23 à 26, dans laquelle le sel d'argent réductible est le nitrate d'argent et le matériau de charge particulaire est constitué de particules de dioxyde de titane, qui sont présentes dans la gamme de 5 à 75 % en poids.

28. Substrat sur lequel est déposée une composition d'encre selon l'une quelconque des revendications 23 à 27, sur un substrat selon un procédé tel que défini dans l'une quelconque des revendications 1. à 22.

29. Kit pour déposer sur un substrat une composition d'encre selon l'une quelconque des revendications 23 à 27, selon un procédé tel que défini dans l'une quelconque des revendications 1 à 22.

30. Utilisation d'une composition d'encre selon les revendications 23 à 27, pour déposer sur un substrat un matériau activateur de dépôt pour un dépôt autocatalytique.
